(19) Europäisches Patentamt
European Patent Office
Office européen des brevets

(11) **EP 2 507 160 B1**

(12) **EUROPEAN PATENT SPECIFICATION**

(45) Date of publication and mention
of the grant of the patent:
**02.04.2014 Bulletin 2014/14**

(21) Application number: **10821457.8**

(22) Date of filing: **06.12.2010**

(51) Int Cl.:
***B81C 1/00*** $^{(2006.01)}$

(86) International application number:
**PCT/IB2010/003502**

(87) International publication number:
**WO 2011/067679 (09.06.2011 Gazette 2011/23)**

(54) **ELECTROMECHANICAL SYSTEMS, WAVEGUIDES AND METHODS OF PRODUCTION USING DENSITY CHANGING SACRIFICIAL LAYERS**

ELEKTROMECHANISCHE SYSTEME, WELLENLEITER UND HERSTELLUNGSVERFAHREN MIT DICHTEVERÄNDERTEN OPFERSCHICHTEN

SYSTÈMES ÉLECTROMÉCANIQUES, GUIDES D'ONDES ET PROCÉDÉS DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.12.2009 US 267027 P**

(43) Date of publication of application:
**10.10.2012 Bulletin 2012/41**

(73) Proprietor: **Scannanotek OY**
**20520 Turku (FI)**

(72) Inventors:
• **PAVLOV, Andrei, Jurievich**
**FIN-21110 Naantali (FI)**
• **PAVLOVA, Yelena, Vasiljevna**
**FIN-21110 Naantali (FI)**

(74) Representative: **Turun Patenttitoimisto Oy et al**
**P.O. Box 99**
**20521 Turku (FI)**

(56) References cited:
**US-A1- 2005 036 269    US-A1- 2005 130 360**

• **DECELLE J ET AL: "Oxidation induced shrinkage for thermally aged epoxy networks", POLYMER DEGRADATION AND STABILITY, BARKING, GB, vol. 81, no. 2, 1 January 2003 (2003-01-01), pages 239-248, XP004433130, ISSN: 0141-3910, DOI: 10.1016/S0141-3910(03)00094-6**

**Description**

**BACKGROUND**

1. Field of Invention

The current claims relate to electromechanical systems and waveguides, devices that incorporate the electromechanical systems and waveguides, and methods of production.

2. Discussion of Related Art

Microelectromechanical systems (MEMS) devices comprise microstructures that are usually separated from other control elements, for example control electrodes, by narrow air gaps. The MEMS devices have movable structures that can move over the space provided by the gap. Usually, this movement is used to make a contact with an electrode, such as in a MEMS switch. Variation of the width of the gap can be used to change electrical characteristics of the device, such as a variable capacitor. In many applications, the MEMS structure is used as a sensitive element and the movement of the microstructure is used to detect an external effect such as pressure, acceleration, etc. In many applications, performance of the MEMS structure is limited by the size of the gap. Larger gaps require greater forces to enable the MEMS structure to move. Accordingly, the sensitivity of the MEMS structure is lower for larger gaps and higher power is needed to control it. For example, electrical voltages that are needed for the operation of MEMS devices is relatively high, i.e., of the order of a few tens of Volts. To improve performance of MEMS devices, significantly smaller gaps are needed. The smaller gaps can improve sensitivity and allow for lower power operation of the devices. Most traditional MEMS devices require a vacuum in the gap and, therefore, require special protection from ambient atmosphere, such as sealing and encapsulation.

MEMS structures are usually produced using a layer referred as a sacrificial layer because it is removed during fabrication. The sacrificial layer is prepared in the space which later becomes a gap which separates the movable component of the MEMS structure from other parts of the device, for example, control electrodes. The sacrificial layer is temporarily included in the device to enable preparation of the movable component of the MEMS structure on top of it. After that, the sacrificial layer is removed by etching to provide the gap that separates the movable component of the MEMS structure and the electrodes. Typical production process are described in US 2005/0130360 and US 2005/0036269. The use of the sacrificial layer and etching process limits the minimum size of the gap because it is more difficult to etch thinner sacrificial layer materials underneath the top structure. To improve etching processes one can make holes in the movable component of the MEMS structure. However, the smallest gaps obtained by this approach are in the range from 1 to 1.5 micrometers. In addition, the etching process is incompatible with the production of many electronic circuits on the same substrate, such as CMOS integrated circuits. Therefore, there remains a need for improved electromechanical systems, methods of producing electromechanical systems and devices that incorporate the electromechanical systems.

**SUMMARY**

A method of producing an electromechanical device according to an embodiment of the current invention includes forming a layer of density-changing material on a substructure, and forming a support layer on at least a portion of the layer of density-changing material. The density-changing material has a first density during the forming the layer and a second density subsequent to the forming the support layer, the second density being greater than the first density such that the layer of density-changing material shrinks in at least one dimension to provide a gap between the layer of density changing material and at least one of the support layer and the substructure.

A combined electronic and electromechanical device which, by way of an example, may be made by the method of the current invention has a substrate, an electronic circuit formed on the substrate, and an electromechanical system formed on the substrate to provide a combined electronic and electromechanical device on a common substrate. The electromechanical system comprises a structure that is free to move within a gap defined by the electromechanical system.

An electromechanical system which, by way of an example, may be made by the method of the current invention has a substructure, and a movable component attached to the substructure such that a gap is provided between the movable component and the substructure. The gap is less than about 500 nm.

An apparatus which, by way of an example, may be made by the method of the current invention has an electromechanical system that has a substructure, and a movable component attached to the substructure such that a gap is provided between the movable component and the substructure. The gap is less than about 500 nm.

A method of producing a waveguide according to an embodiment of the current invention includes providing a substructure, forming a layer of density-changing material on the substructure, and forming an upper layer on at least a portion of the layer of density-changing material. The density-changing material has a first density during the forming the layer and a second density subsequent to the forming the upper layer, the second density being greater than the first density such that the layer of density-changing material shrinks in at least one dimension to provide a gap between the layer of density changing material and at least one of the upper layer and the substructure.

## BRIEF DESCRIPTION OF THE DRAWINGS

Further objectives and advantages will become apparent from a consideration of the description, drawings, and examples.

**Figure 1** is a schematic illustration of the production of an electromechanical device according to an embodiment of the current invention.

**Figure 2** is a schematic illustration of the production of an electromechanical device according to another embodiment of the current invention.

**Figure 3** is a schematic illustration of the production of an electromechanical device according to another embodiment of the current invention.

**Figure 4** is a schematic illustration of the production of an electromechanical device according to another embodiment of the current invention.

**Figure 5** is a schematic illustration of the production of an electromechanical device according to another embodiment of the current invention.

**Figure 6** is a schematic illustration of an electromechanical exemplary device.

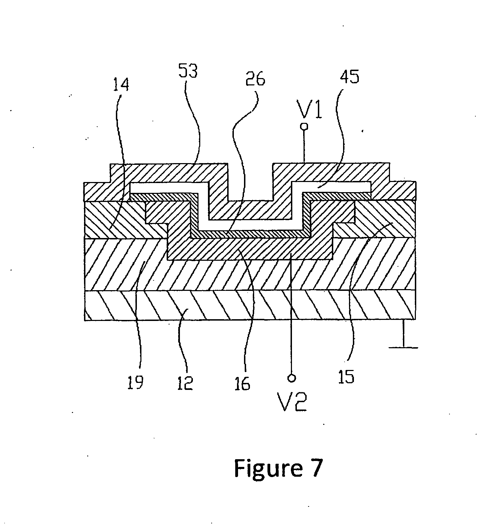

**Figure 7** is a schematic illustration of an electromechanical exemplary device.

**Figure 8** is a schematic illustration of an electromechanical exemplary device.

**Figure 9** is a schematic illustration of an electromechanical exemplary device.

**Figure 10** is a schematic illustration of an electromechanical exemplary device.

**Figure 11** is a schematic illustration of an electromechanical exemplary device.

**Figure 12** is a schematic illustration of an electromechanical exemplary device.

**Figure 13** is a schematic illustration of an electromechanical exemplary device.

**Figure 14** is a schematic illustration of an electromechanical exemplary device.

**Figure 15** is a schematic illustration of an electromechanical exemplary device.

**Figure 16** is a schematic illustration of an electromechanical exemplary device.

**Figure 17** shows an example of a microchip that include both an electronic integrated circuit as well as MEMS devices fabricated on the same substrate.

## DETAILED DESCRIPTION

Some embodimnets of the current invention are directed to Microelectromechanical systems (MEMS) and nano-electromechanical systems (NEMS) and methods of producing the MEMS and NEMS. The MEMS and NEMS according to some embodiments of the current invention can be applied in RF applications, mobile technologies, photonics, energy, solar cells, telecommunications, transistors and diodes for example. Methods of fabricating MEMS and NEMS devices according to some embodiments of the current invention allow the fabrication of structures having nanogaps which are significantly smaller than 1 micrometer and can be as small as a few nanometers in size, or even less than 1 nm (e.g., 0.5 nm). (In the remainder of this description, we often refer to MEMS devices, but that should be interpreted as including NEMS devices.) There can be several nanogaps in one device and the device may have multigap or multi-nanogap structures, according to some embodiments of the current invention. Such structures can be used, for example, in transistors. In addition, methods of producing devices according to some embodiments of the current invention allow us to simplify fabrication of MEMS devices by avoiding encapsulation or other protection procedures such as sealing, etc. In addition, methods of production according to some embodiments of the current invention can also be used for encapsulation of devices. The fabrication methods according to some embodiments of the current invention can be used to make planar waveguides for light transmission or transmission lines for RF signals of high frequency in the GHz range. Long structures having nanogaps inside can be a new type of nanotubes. In addition, fabrication methods according to some embodiments of the current invention allow for the fabrication of vacuum gaps that do not need special sealing or protection against ambient atmosphere. For example, fabrication methods according to some embodiments of the current invention allow for fabrication of gaps inside the material and therefore, the gap automatically provides a vacuum relative to the surrounding environment.

The term vacuum as used here is intended to have a broad meaning to include partial vacuums as well as substantially complete vacuums, as long as the gas pressure within the gap is less than that of the surrounding environment. Nonetheless, in some cases, the vacuum can also be a high vacuum so that there is little easily discernable gas in the gap.

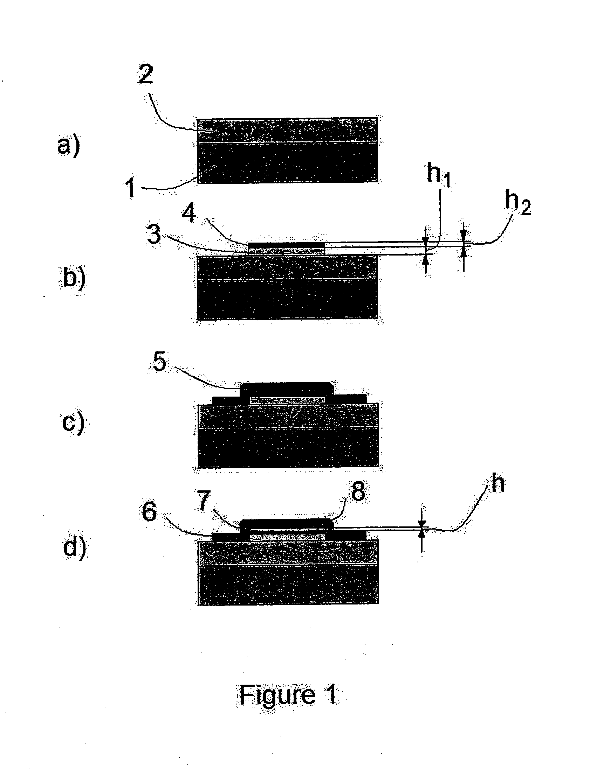

An embodiment of the current invention provides a method of fabricating ultrathin gaps that can have a size of few nanometers, for example. We call this gap a nanogap. According to some aspects of the current invention, the nanogap can be formed when two or more specially chosen materials chemically react with each other to form a final material with higher density than the initial materials. Accordingly, the higher density will result in smaller volume. If these materials are placed between two solid structures, then the chemical reaction will lead to shrinking the volume occupied by the inner material. As a result, the difference between the initial volume and the final volume will release an empty space that will form the gap. The greater the difference between the densities of initial components and the density of the final material, the larger the volume that can be released. In addition to chemical reaction, a diffusion process can take place. The fabrication of an example of a device that has a nanogap according to an embodiment of the current invention is illustrated schematically in Figure 1.

In Figure 1, stage a) shows a substrate 1 and an isolation layer 2 on top of it. Stage b) shows two layers, material $M_1$ 3 and material $M_2$ 4 on top of it. The bottom layer $M_1$ has thickness $h_1$ and the top layer has thickness $h_2$. Both materials form a structure having thickness $h_1 + h_2$. Stage c) shows a structure 5 prepared on top of the layers 3 and 4. During stage d) materials $M_1$ and $M_2$ are reacting with each other with formation of materials $M_{1x}$ 6 and $M_{2x}$ 7. The new materials have higher density and accordingly smaller volume, releasing a gap 8 with thickness hg. The thickness hg can be calculated from the difference between the initial volume and final volume of the layered structure.

The effect can be estimated mathematically using the law of conservation of mass. For example, consider the case in which the initial density of the first layer is $\rho_1$ and its thickness is $h_1$, and the initial density of the second layer is $\rho_2$ with a thickness of $h_2$. After the reaction, the density of the first layer changes to $\rho_{1x}$, and its thickness changes to $h_{1x}$, and the density of the second layer changes to $\rho_{2x}$ and its thickness changes to $h_{2x}$. The gap hg can be obtained from the following relation

$$h_1 + h_2 = h_{1x} + h_{2x} + h_g \ . \tag{1}$$

Using the law of conservation of mass leads to the relation

$$\rho_1 h_1 + \rho_2 h_2 = \rho_{1x} h_{1x} + \rho_{2x} h_{2x}, \tag{2}$$

where one can assume that thin layers change their volumes along thickness and don't change their surface areas. One can be seen from these equations that different conditions can result in providing a gap, as follows:

1. $\rho_1 < \rho_{1x}$ ; $h_1 < h_{1x}$ ; $\rho_2 < \rho_{2x}$ and $h_2 < h_{2x}$. Both layers become thinner and the gap hg is a sum of two effects $h = (h_1 - h_{1x}) + (h_2 - h_{2x})$.

2. $\rho_1 < \rho_{1x}$ ; $h_1 < h_{1x}$ ; $\rho_2 > \rho_{2x}$ and $h_2 > h_{2x}$. One layer becomes thinner, another layer thicker. However, the final result is obtained from the difference $h = (h_1 - h_{1x}) - (h_{2x} - h_2)$.

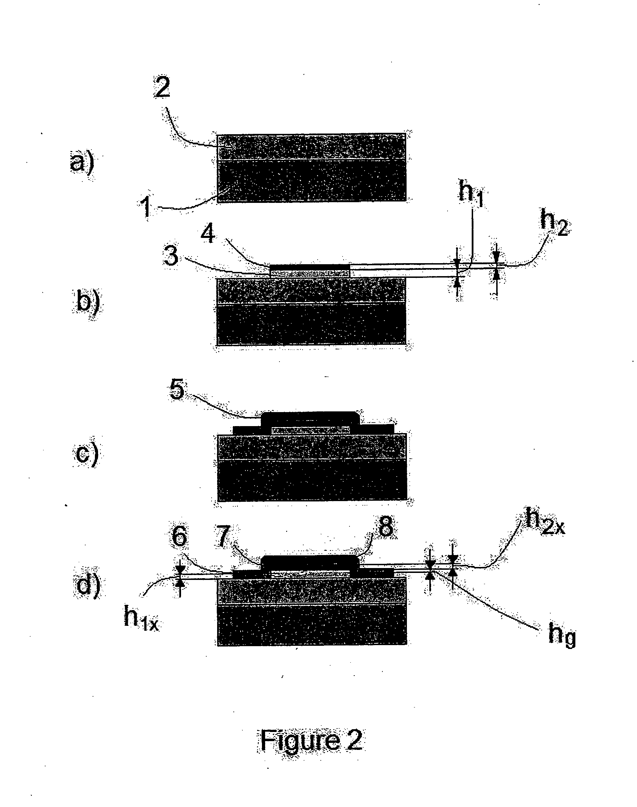

The nanogap can be formed above the layered structure during shrinking as shown in Figure 1, or within the layered structure as shown in Figure 2. In the Figure 2, the top layer $M_2$ is fixed to the MEMS structure. This can be caused by significant adhesion between the material $M_2$ and material of the MEMS structure, or by chemical reaction between the MEMS material and $M_2$.

According to another embodiment of the current invention, there can be combinations of three or more layers. The chemical reaction can occur with three or more participating layers. Accordingly, the final effect will be obtained from similar equations. For example, for three layers

$$h_1 + h_2 + h_3 = h_{1x} + h_{2x} + h_{3x} + h_g \, , \qquad (3)$$

and from law of conservation of mass

$$\rho_1 h_1 + \rho_2 h_2 + \rho_3 h_3 = \rho_{1x} h_{1x} + \rho_{2x} h_{2x} + \rho_{3x} h_{3x} \, . \qquad (4)$$

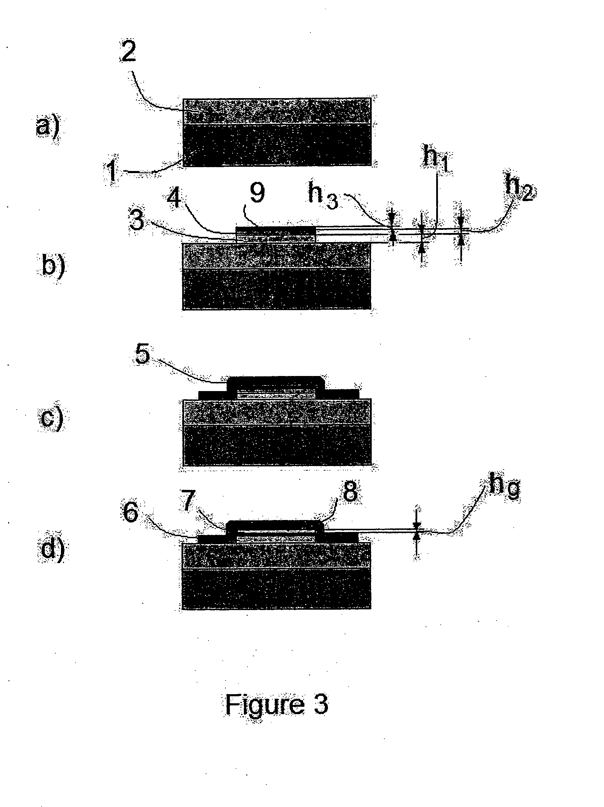

Figure 3 shows an example where three layers $M_1$ 3 $M_2$ 4 and $M_3$ 9 are deposited with corresponding thicknesses $h_1$, $h_2$, and $h_3$. The gap hg is formed during reaction of the three materials.

Similarly, one can design more complex reactions when chemical reactions take place in separate stages, for example, material $M_1$ can react first with material $M_2$ to form material $M_{12}$. Then material $M_{12}$ reacts with material $M_3$ resulting in material $M_{123}$ etc. Physical diffusion, temperature, radiation, incident illumination and other physical processes can be used to control the reaction.

According to further embodiments of the current invention, more complex structures can be used for the fabrication of more than one nanogap in a device. One can prepare two or more gaps in one device by methods similar to those described above. Furthermore, a single layer of material can also be used to produce structures that have a gap. For example, the single layer can undergo a phase change such that the final phase has a greater density than the initial phase. In another embodiment, the single layer could undergo sublimation such that the layer increases in density. Furthermore, phase changes and/or sublimation processes could be combined with chemical reactions in more complex layer structures in some embodiments of the current invention.

In a more general sense, a method of producing an electromechanical device according to an embodiment of the current invention includes forming a layer of density-changing material on a substructure, and forming a support layer on at least a portion of the layer of density-changing material. The density-changing material has a first density during the forming the layer and a second density subsequent to the forming the support layer, the second density being greater than the first density such that the layer of density-changing material shrinks in at least one dimension to provide a gap between the layer of density changing material and at least one of the support layer and the substructure.

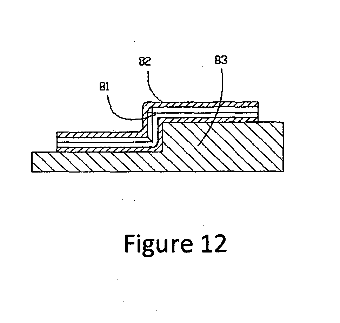

The substructure can be a substrate in some embodiments of the current invention, or can be a more complex structure. For example, the substructure in the example of Figure 1 includes the substrate 1 and the isolation layer 2. The substructure can be more complex structures in other embodiments of the current invention. It may have, for example, a step-like structure, see Figure 12, and the gap can be formed along the step structure. The layer of density changing material can be a layer of a single material, a layer of multiple materials or a layer that includes two or more sub-layers of materials, for example. The support layer can be any structure suitable for the particular application that attaches to at least a portion of the layer of density-changing material. In some cases the support layer can provide a portion of the structure such that the gap will provide a vacuum. In the example of Figure 1, the structure 5 is an example of a support layer that provides, along with isolation layer 2 and layers 6 and 7, an enclosed structure such that the gap 8 will be a vacuum.

The density-changing material changes density due to a phase change in its structure in some embodiments of the current invention. In other embodiments, the density-changing material changes density due to sublimation. In further embodiments, the density changing material changes density due to one or more chemical reactions. In some embodiments, the density changing material changes density as the result of a combination of one of more of a phase change, sublimation, chemical reactions or diffusion.

In some embodiments of the current invention, the layer of density-changing material provides a membrane structure after it shrinks. In some embodiments, the membrane can be formed in a vacuum relative to a surrounding environment. In other embodiments, external components can form a membrane, such as the structure 5 in the example of Figure 1. In some embodiments, the support layer is formed over a portion of the layer of density-changing material leaving an end of the density-changing material uncovered such that the layer of density-changing material provides a cantilever structure after it shrinks in at least one dimension.

In some embodiments, energy is transferred to the layer of density-changing material to initiate a phase change, sublimation and/or a chemical reaction. The energy transfer can include at least one of heating, passing an electrical current through the layer of density-changing material, or directing radiation onto the layer of density-changing material The radiation can be electromagnetic radiation, for example.

The forming the layer of density-changing material can include forming a plurality of sub layers of respective pluralities of materials. The general concepts of the current invention are not limited to a particular number of sub-layers of materials, which can be two, three or more than three sub-layers, for example.

In some embodiments of the current invention, the gap is less than 1 $\mu$m such that said electromechanical device is a micro-electromechanical system or nano-electromechanical system. However, the general concepts of the method of producing electromechanical devices are not limited to producing only MEMS and NEMS devices. Devices with larger gaps can also be produced according to some embodiments of the current invention. In some embodiments, the gap is less than 0.5 $\mu$m such that the electromechanical device produced is a nano-electromechanical system. In further embodiments, the gap in the NEMS devices produced is less than 1 $\mu$m and greater than 0.5 nm, and in some embodiments the gap is less than 0.5 $\mu$m and greater than 0.5 nm.

An exemplary device is an electromechanical system that has a substructure, and a movable component attached to the substructure such that a gap is provided between the movable component and the substructure. The gap is less than about 500 nm. In some embodiments, the gap is less than about 200 nm. In further embodiments, the gap is less than about 100 nm and greater than about 0.5 nm.

The movable component can be a membrane in some examples or cantilever (see, for example, U.S. Patent Application No. 12/370,882 by A. Pavlov et al., "Resonant MEMS Device that Detects Photons, Particles and Small Forces", filed Februar 13, 2009, the entire content of which is incoporated herein by reference) in some examples or a bridge-like structure. The electromechanical system can include enclosing structures in some examples such that the gap is substantially a vacuum relative to a surrounding environment.

Further examples include an apparatus that includes one or more electromechanical systems according to the current description. Another embodiment of the current invention is directed to a method of producing a waveguide that includes providing a substructure; forming a layer of density-changing material on the substructure; and forming an upper layer on at least a portion of the layer of density-changing material. The density-changing material has a first density during the forming the layer and a second density subsequent to the forming the upper layer, the second density being greater than the first density such that the layer of density-changing material shrinks in at least one dimension to provide a gap between the layer of density changing material and at least one of the upper layer and the substructure.

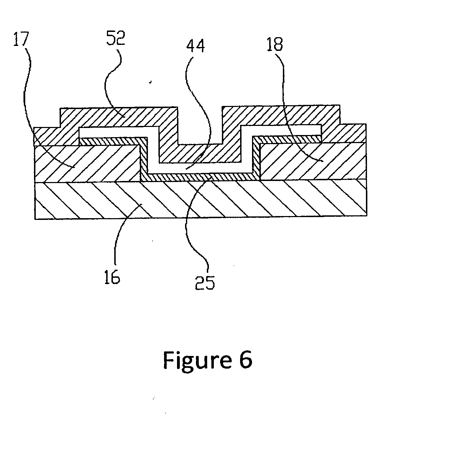

An example of a device based on the fabrication method according to an embodiment of the current invention is shown in Figure 6. Here the nanogap is prepared on the step structure showing the possibility for different device design. The step structure is formed from a substrate 16, second layer 17, 18 forming the step structure, density-changing layer 25, top structure 52 and the nanogap 44. The top structure 25 can have a step profile as well. For example, if the device is prepared by a CMOS process where the layer has a nearuniform thickness, for example, when the deposition is made using physical vapor deposition, magnetron sputtering, chemical vapor deposition and others, then the layer will form the profile correlated to that of structures underneath.

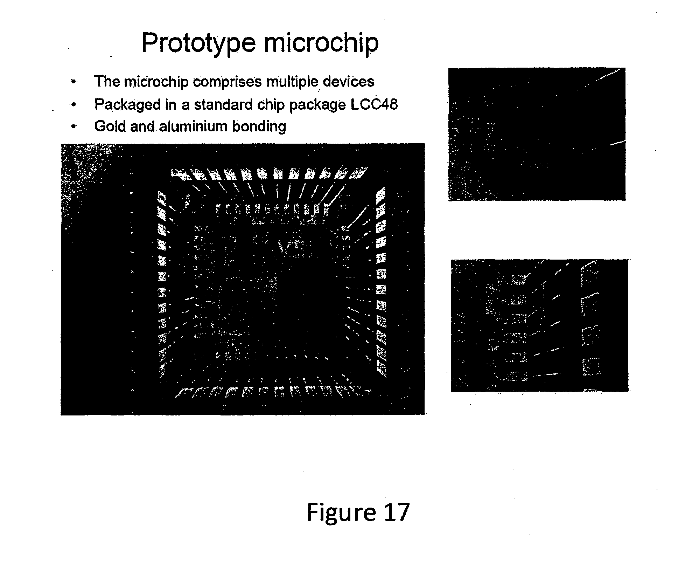

Figure 17 shows an exemplary device, i.e., variable capacitor or varactor. The device comprises a substrate 12, resistive layer 19, next resistive layer 14,15; bottom electrode 16, density-changing layer 26, top MEMS structure 53 and nanogap 45. The nanogap's size may vary, for example, from 1 nm to 100 nm. The device is a two-terminal device and electrical connection is made between the bottom electrode 16 and the top structure 53. Small gaps allow one to make smaller sized devices yet with sufficiently large capacitance values. The capacitance is varied by applying voltage to the device resulting in variation of the gap size. A smaller gap results in increase of the capacitance value. The geometry of the device can be simpler if the layer 14,15 is skipped from the design. Electrical connection to the bottom electrode can be made using a side electrode connection going in the isolation layer, or using a via which is a standard/common solution for connection.

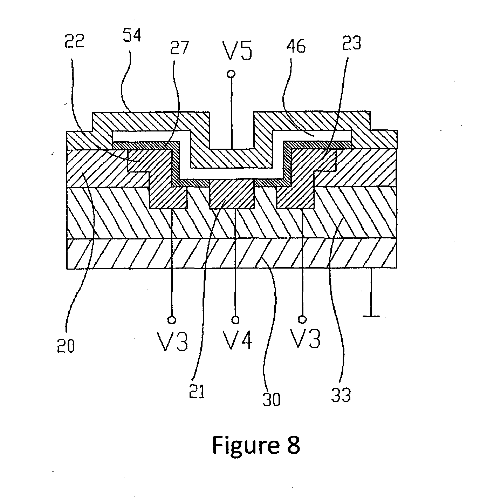

Figure 8 shows an exemplary switch device that can be used in RF applications. The device comprises a substrate 30, resistive layer 33, another resistive layer 20 forming step structures, electrodes 21,22 and 23; density-changing layer 27, top MEMS structure 54 and nanogap 46. The electrode 21 is used for switching. Its top surface is slightly closer to the MEMS structure than those of other electrodes. Switching is performed between the MEMS structure 54 and the electrode 21 forming an Ohmic contact with low resistance. Other electrodes 22, 23 can geometrically surround the electrode 21 and electrically the electrodes 22 and 23 can be connected to each other. These electrodes are used for actuation of the device. When an electrical voltage is applied to the electrodes 22, 23 the MEMS structure moves closer to the electrode 21, and at a certain voltage switching is performed between 54 and 21. The electrodes 22,23 are placed at lager distance from the MEMS structure than the electrode 21 to avoid leakage current at switching. The top MEMS structure may be a membrane, bridge-like structure or cantilever. Variations in geometry of the top MEMS structure allow different geometries of the structures underneath. The step structure can be avoided or skipped in some designs so then the device may have a simpler geometry. Connection to bottom electrodes can be performed by using side electrodes going underneath in the isolation layer, or using vias.

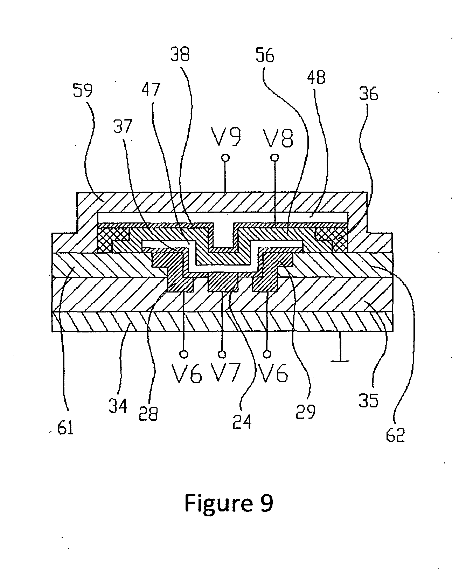

Figure 9 shows an exemplary device with two gaps. This additional gap may have different functions. It can, for example, isolate the operating MEMS structure from the environment, or, it can separate different electrodes in more complex designs. The device of Figure 9 comprises a substrate 34, isolation layer 35, another isolation layer 61,62 forming step structure, bottom electrodes 24,28,29; density-changing layer 37, MEMS structure 56, another density-changing layer 38, top layer 59 and two gaps 47 and 48. The device can work as a switch. The gap 48 is used to isolate the MEMS structure from influence of external forces like air pressure. This design allows different geometries of the MEMS structure 56 and bottom electrodes. The MEMS structure 56 can be a membrane, bridge, comb structure or a cantilever. Bridge- and cantilever designs allow connection between the gaps so that the MEMS structure 56 can be surrounded by a vacuum. The electrodes 28 and 29 can be connected to each another.

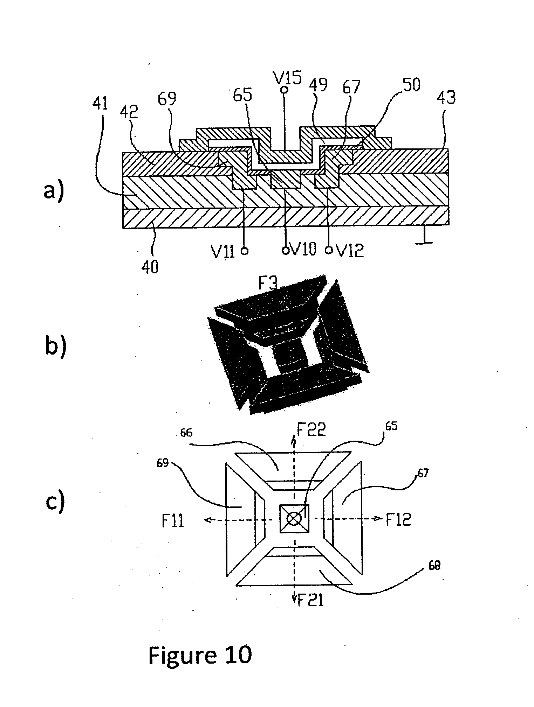

Figure 10a shows an exemplary device that can work as an accelerometer. The device comprises a substrate 40, isolation layer 41, another isolation layer 42, 43 forming step structure; electrodes 65, 66, 67,68 and 69; density-changing layer 50, nanogap 49 and a top MEMS structure. In this device electrodes are separated from each other and can sense motion of the MEMS structure in different direction sensing forces F11,F12, F21,F22 and F3 shown in Figure 10c. In this device the MEMS structure can move not only vertically but also in a horizontal plane so that distances to different contacts can be changed. Figure 10b shows schematically the electrodes. They are separated from each other. Other designs and shapes of the electrodes can be also used.

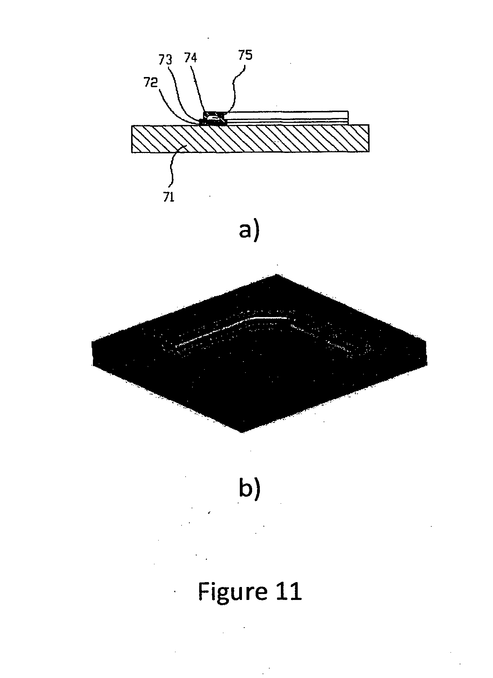

The term "waveguide" is considered in a broad sense to mean that the device can transfer electro-magnetic waves, light, radiation or electrical charge depending on materials forming the waveguide. For transferring light or radiation it is an optical waveguide. For transferring electrical charge it is a nanotube. Accordingly, materials for the device will vary depending on the application. Prior art optical waveguides use photonic crystal fibers or hollow fibers. The prior art fibers cannot be integrated on a chip with other devices like laser diodes and photodetectors and they are limited by a few materials that can be used in the process. We disclose a waveguide device that can be made of different materials, the inner gap can be very small, of the nanometer size, and the size can be predicted with a very good accuracy. An example of a waveguide device made by a method according to the current invention is shown in Figure 11. The device is made on a substrate 71 and comprises a first layer 72, density-changing layer 73, top structure 74 and a gap 75. The waveguide can have a wide range of geometries that can be realized by lithography. This waveguide can be integrated with other devices on the same chip according to some embodiments of the current invention. One can consider the waveguide as an on-chip waveguide. Figure 11b shows a perspective view of the waveguide. Depending on the wavelength, one can use different materials for the structure including semiconductor materials. The inner gap of the waveguide can be filled with a gas or liquid to obtain suitable optical characteristics.

Figure 12 shows a waveguide that is prepared on a step-like structure. The device is prepared on a substrate 83 and comprises the structure 82 and a gap 81 that goes along the step structure. This picture demonstrates a possibility to design 3D waveguides on a chip.

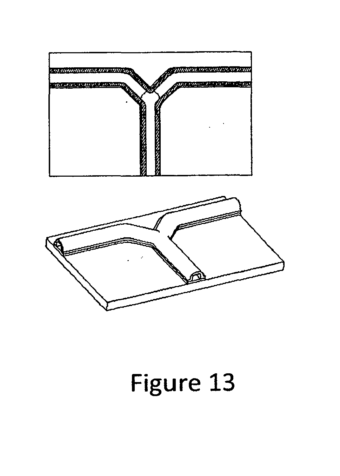

Figure 13 shows a waveguide that splits into several branches. This picture shows that this waveguide can be used in advanced designs including optical switching matrixes, logical devices and others.

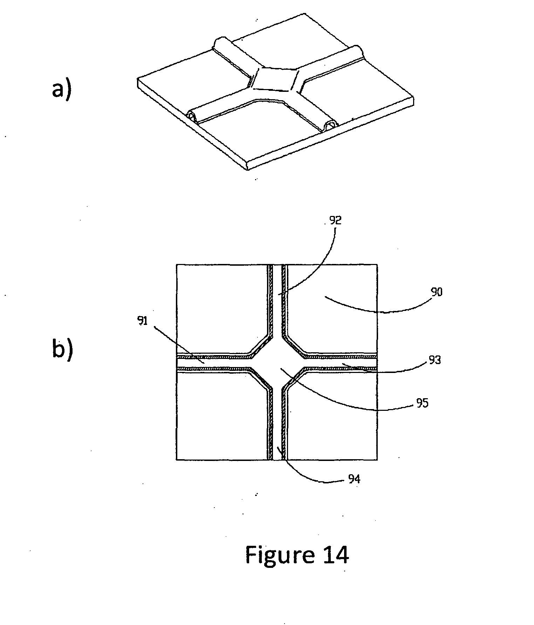

Figure 14 shows a waveguide device an example of that comprises a substrate 90 and four waveguides 91, 92, 93 and 94. The waveguides are connected to cavity 95. This basic structure can be used for connecting different waveguides.

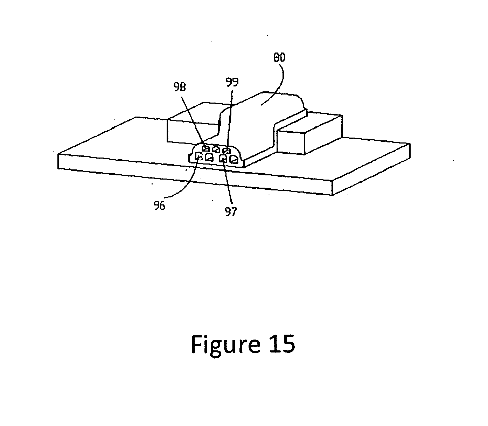

Figure 15 shows a waveguide 80 an example of with a multi-gap structure inside 96, 97, 98, 99 etc. Also, the device goes through a step structure.

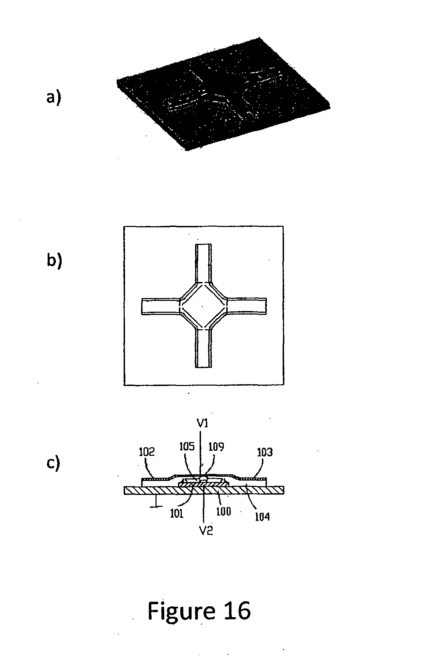

Figure 16 shows a device where a MEMS device and waveguides are connected together according to an embodiment of the current invention. The combined structure can be used in a switching matrix, for tuning signals, logical circuits, resonators and other devices. Figure 16a shows a general view of the device. Figure 16b shows four waveguides connected to the MEMS device. Figure 16c shows a MEMS device and fractions of the waveguides 102 and 103. The device comprises a substrate 100, bottom electrode 101, top electrode 109 and gaps 104 inside the waveguides and 105 in the MEMS device. The MEMS device can be actuated, for example, electrically. The waveguides can be used for transferring signals. The MEMS device can sense signals going through the waveguides and can modulate the signals. Waveguides and the MEMS device can be made of different materials. Materials for the optical waveguides can be chosen from resistive or semiconductor ones providing electrical isolation. The MEMS device may have a more complex design based on the fabrication method and devices according to some embodiments of the current invention. The geometry of the waveguide, including geometry of the gap, can change along the device. For some applications, different parts of the waveguide can be made of different materials including semiconductors. This allows one to design devices not only vertically but also horizontally.

## EXAMPLES

One can estimate the effect, for example, for aluminum (Al). It has a density of 2.7 g/cm$^3$. When Al reacts with oxygen, the oxide $Al_2O_3$ will have a density of 3.96 g/cm$^3$. If one deposits a thin layer of Al on a substrate, then oxidation will result in decreasing its thickness because the density of the oxide is greater than that of Al and the thickness of the oxide will be accordingly smaller. The relation can be obtained, taking into account that the total mass of the layer remains almost the same, i.e. if the initial thickness of the layer is $h_1$, initial density $\rho_1$, thickness after oxidation $h_{1x}$ and final density $\rho_{1x}$, then $h_{1x}=h_1\,\rho_1/\rho_{1x}$. The thickness of $Al_2O_3$ will be thinner by a ratio of 2.7/3.96=0.68, or 68% of the initial thickness. If, for example, the initial thickness is 10 nm, then the final thickness will be about 7 nm. When the initial layer is placed between two fixed plates, such shrinking of the layer will release a gap of about 3 nm. If the layer is prepared inside (surrounded by or enveloped by) the other material, the gap will be substantially a vacuum with respect to the surrounding environment formed inside the structure.

**Reaction time**

The formation of the nanogap according to some embodiments of the current invention depends on reaction time within the layered structure. There are three main cases:

1. Reaction time is long. This time is sufficiently longer than the time required for preparing the MEMS structure on top of it. This is the case when one wants to utilize the maximum effect from density increase. This case also can be used to make larger gaps.

2. Reaction time is short. The layers react before the MEMS structure is deposited. To slow down the reaction time one can use a buffer layer between the reacting layers to create time delay of the beginning of the reaction. For example, in Figure 3 the material $M_2$ 4 can be the buffer layer. It allows reacting atoms of the material $M_3$ 9 to reach the layer $M_1$3. For example, when reaction occurs in layer $M_1$ 3 with oxygen atoms coming from the layer $M_3$ 9, the delay time is determined by the time needed for oxygen atoms/ions to cross the layer $M_2$ 4. The material for the buffer layer lets atoms travel through the buffer layer without reacting with the atoms. For example, in a reaction with oxygen the buffer layer can be a material that does not react with oxygen. The buffer layer can be made of carbon C, inert metals like Pt, Mo, Wo, Mg with Pt, nonmetals, polymers etc.

3. Reaction time is moderate. There can be applications when the reaction time of the layered structure can be of the same order as the time for fabrication of the MEMS structure. This is the case when one wants to use only part of the effect for obtaining smaller gaps.

Electronegativity of the materials can be chosen for particular applications. The buffer layer can also be used for the transfer of charge and electrons according to some embodiments of the current invention. The thickness of the buffer layer can change too in some embodiments of the current invention.

**Materials**

Below are some combinations of materials that can be used for some applications of some embodiments of the current invention. However, the general concepts of the current invention are not limited to only these examples.
Metals, oxides and modifications:

| Material | density, g/cm$^3$ |
| --- | --- |
| Al | 2.7 |
| $Al_2O_3$ | 3.96 |
| $Al_2SiO_5$ | 3.25 |

Some embodiments of the current invention can utilize the following regularities: formation of oxides of light metals such as sodium Na, potassium K, calcium Ca, lithium Li, magnesium Ma, beryllium Be, and others will result in an increase of the density; on the other hand, formation of oxides of heavy metals results in a decrease of the density.
Almost all inter-oxide compounds form with a decrease in density. However, increases of density can be obtained in phase transitions in metals. For example, ordinary white tin alpha-Sn has a density of 5.85 g/cm$^3$. It transforms to gray-tin $\beta$-Sn at temperature minus 20 °C. The $\beta$-Sn has a density of 7.29 g/cm$^3$.
Increases of density can be obtained in phase transitions in oxides. For example, $TiO_2$ anataz has density of 3.8 g/cm$^3$, but $TiO_2$ rutile has density of 4.2-4.3 g/cm$^3$. One can add a small fraction of another material such as niobium Nb or tantalum Ta to control the electrical conductivity.
Other examples include, but are not limited to,

$$\alpha\text{-}Ga_2O_3 \;(5.88 \text{ g/cm}^3) \rightarrow \beta\text{-}Ga_2O_3 \;(6.48 \text{ g/cm}^3);$$

$\beta$-GeO$_2$ (4.70 g/cm$^3$) $\rightarrow$ $\alpha$-GeO$_2$ (6.24 g/cm$^3$); and

Hexagonal SiO$_2$ (2.65 g/cm$^3$) $\rightarrow$ Tetragonal SiO$_2$ (3.44 g/cm$^3$).

Density can increase in reactions that lead to a decrease of Entropy. For example, density can increase as a result of reaction of oxides of a metal having different oxidation ratios. For example, oxide of Bismuth (II) BiO having density of 7.20 g/cm$^3$ reacts with oxide of Bismuth (V) Bi$_2$O$_5$ having a density 5.10 g/cm$^3$ to form the oxide of Bismuth (III):

$$4BiO + Bi_2O_5 = 3Bi_2O_3.$$

The resultant oxide Bi$_2$O$_3$ has a density of 8.9 g/cm$^3$. Here 4 molecules of BiO and one molecule of Bi$_2$O$_5$ form 3 molecules Bi$_2$O$_3$. The reaction leads to a decrease of molecular volume, and accordingly a decrease of Entropy.

An increase of density can be obtained by sublimation of some easily evaporating volatile oxides: OsO$_4$ (evaporation temperature 131 °C), Re$_2$O$_7$ (evaporating temperature 359 °C), for example.

An increase of density can be obtained during reduction of oxides of heavy metals with hydrogen:

$$CuO + H_2 = Cu + H_2O.$$

Density can be significantly increased by reduction reactions of oxides of heavy metals releasing the metals. Some oxides, for example, oxides of Au, Ag, Pt and Ir metals decompose under heating to yield the metal and oxygen, such as:

$$Ag_2O \rightarrow 2Ag + \tfrac{1}{2} O_2 \ (T{>=}200 \ °C)$$

$$IrO_2 \rightarrow Ir + O_2 \ (T{>}1000 \ °C)$$

In the latter reaction, the density will increase from 3.15 g/cm$^3$ for IrO$_2$ to 22.4 g/cm$^3$ for Ir.

Oxides of Noble metals can be reduced by hydrogen too.

The reaction can be enhanced by thermal conditions, electromagnetic fields, illumination of light or radiation. One can use DC electrostatic fields or AC variable electrical fields or variable electrical fields at resonant oscillation of the MEMS structure.

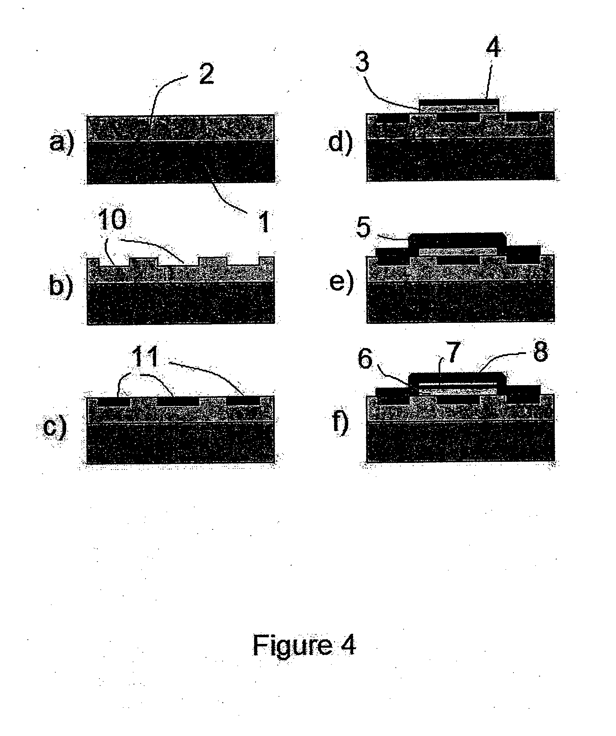

Figure 4 shows the fabrication process of a MEMS device with electrode structures using CMOS fabrication procedures. Stage a) shows the substrate 1 and an isolation layer 2. For example, a Si wafer can be thermally oxidized to obtain the isolation layer. Stage b) shows etching of grooves for the electrodes. The proper geometry is obtained by using masks and accurate lithography. Alternatively, fine geometry can be made by direct writing, for example, by electron or optical beam. Stage c) shows deposition of electrodes in the grooves. Stage d) shows a layered structure on top of the sample. Stage e) shows the MEMS structure on top of the layered structure having contacts with side electrodes. Stage f) shows the formation of the vacuum nanogap. The nanogap is isolated from ambient atmosphere. The device shown in Figure 4 can be used in many MEMS applications, including, but not limited to, RF MEMS switches, variable capacitors, varactors, thin film transistors, diodes and/or other tunable components, such as pressure sensors, accelerometers, detectors of a small force, including atomic force, and others. The gap can vary from a few nanometers to the micrometer range for example, depending on the application. In the extreme case, gaps of that are a fraction of a nanometer can be produced according to some embodiments of the current invention.

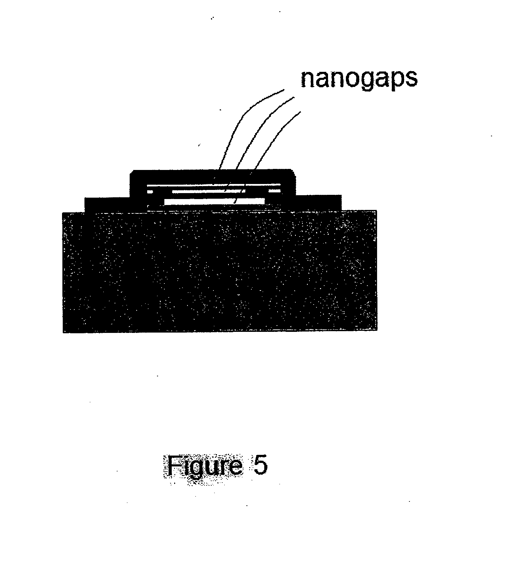

Figure 5 shows a MEMS device with a multi-gap structure. In that particular example, there are three gaps shown, however the general concepts of the invention are not limited to a particular number of gaps.

In an embodiment of the current invention, two or more layered structures can be used for fabrication of multigaps in one device.

Below are some examples of materials that can be used for the formation of vacuum cavities using reduction of Cu from CuO.

The Copper can be reduced from its oxide. There are the following reactions:

CuO-Ti

$$2CuO + Ti = TiO_2 + 2Cu \qquad (1)$$

$$\Delta H: 2*162+0-944=-620 \text{ kJ}$$

The reaction is thermodynamically beneficial and will result in emission of heat.
All initial atoms/substances will react if we use the following proportion:
2 moles of CuO and 1 mole of Ti will result in formation of 1 mole of $TiO_2$ and 2 moles of Cu.

| Substance | **CuO** | **Cu** | **Ti** | **TiO$_2$** |
|---|---|---|---|---|
| Mass 1 mole, g | 80 | 64 | 47.8 | 80 |
| Density, g/cm$^3$ | 6.45 | 8.96 | 4.5 | 4.2 |

One can calculate thickness h of the films per square unit needed for full reaction, i initial substances will fully react, as:

$$h \text{ CuO} = (2*80)/6.45=24.8 \text{ nm}$$

$$h \text{ Ti} = (47.8)/4.5=10.6 \text{ nm}$$

$$h \text{ TiO}_2+Cu=(80)/4.2+(2*64)/8.96=19+14=33 \text{ nm}$$

The change of the thickness is

$$\Delta h = 35.4 - 33 = 2.3 \text{ nm } (6.5\%).$$

CuO - Al

The reaction of CuO and Al is the following

$$3CuO + 2\,Al = Al_2O_3 + 3Cu \qquad (2)$$

$$\Delta H: \quad 3 \cdot 162 + 0 - 1676 = -1190 \text{ kJ}$$

Again, the reaction is thermodynamically advantageous and is accompanied by heat emission.
In order for all compounds/substances to have reacted completely, there should be 3 mole of CuO and 2 mole of Al, resulting in formation of 1 mole of $Al_2O_3$ and 2 mole of Cu.
One can calculate thicknesses of the films per square unit so that the substances have reacted completely

| Compound/substance | **CuO** | **Cu** | **Al** | **Al$_2$O$_3$** |
|---|---|---|---|---|
| Mass 1 mole, g | 80 | 64 | 27 | 102 |
| Density, g/cm$^3$ | 6.45 | 8.96 | 2.7 | 3.96 |

$$h \text{ NiO} = (3 \cdot 80)/6.45 = 37.2 \text{ nm}$$

$$h \text{ Al} = (2 \cdot 27)/2.7 = 20 \text{ nm}$$

$$h\ Al_2O_3 + Cu = (102)/3{,}96 + (3{\cdot}64)/8{,}96 = 26 + 21 = 47\ nm$$

$$\Delta h = 57 - 46 = 11\ nm\ (19\%).$$

Reduction of the thickness is 19%.

CuO - Mg

Reaction of CuO with Mg is goes in accordance with the formula

$$CuO + Mg = MgO + Cu \qquad (3)$$

$$\Delta H:\quad 162\ + 0\ -\ 601\ = -\ 439\ kJ$$

The reaction is thermodynamically advantageous and is accompanied by heat emission.
For complete reaction, one can take 1 mole of CuO and 1 mole of Mg, resulting in 1 mole of MgO and 1 mole of Cu.

| Substance | CuO | Cu | Mg | MgO |
|---|---|---|---|---|
| Mass 1 mole, g | 80 | 64 | 24.3 | 40.3 |
| Density, g/cm$^3$ | 6.45 | 8.96 | 1.74 | 3.58 |

For full reaction of the films per square unit thicknesses of the films are

h CuO = (80)/6.45 = 12 nm

h Mg = (24.3)/1.74 = 14 nm

$$h\ MgO + Cu = (40)/3.58 + (64)/8.96 = 11 + 7 = 18\ nm$$

$$\Delta h = 26 - 18 = 8\ nm\ (30\%).$$

Reduction of thickness is 30%

CuO - Ca

CuO + Ca = Cu + CaO          (4)

$$\Delta H:\quad 162 + 0\ -\ 635\ = -\ 473\ kJ$$

The reaction is thermodynamically advantageous and is accompanied by heat emission. In order for the substances to have reacted completely, one needs to take 1 mole of CuO and 1 mole of Ca, resulting in formation of 1 mole of Cu and 1 mole of CaO.
Given the molar mass and density,

| Substance | CuO | Cu | Ca | CaO |
|---|---|---|---|---|
| Mass 1 mole, g | 80 | 64 | 40.08 | 56 |
| Density, g/cm³ | 6.45 | 8.96 | 1.54 | 3.4 |

One can calculate thicknesses of the films

$$h\ CuO\ = (80)/6.45 = 12.4\ nm$$

$$h\ Ca = (40)/1.54 = 26\ nm$$

$$h\ CaO+\ Cu = (56)/3.4\ + (64)/8.96 = 16 + 7 = 23\ nm$$

$$\Delta h =\ 38 - 23 = 15\ nm\ (40\%).$$

So, reduction of thickness is 40 %.

CuO - Ba

CuO + Ba = Cu + BaO          (5)

$$\Delta H:\ 162\ + 0\ - 548\ = - 307\ kJ$$

The reaction is thermodynamically advantageous and is accompanied by heat emission. In order for the substances to have reacted completely one needs to take 1 mole of CuO and 1 mole of Ba, resulting in formation of 1 mole of Cu and 1 mole of BaO.

Taking into account

| Substance | CuO | Cu | Ba | BaO |
|---|---|---|---|---|
| Mass 1 mole, g | 80 | 64 | 137.3 | 153.3 |
| Density, g/cm³ | 6.45 | 8.96 | 3.76 | 5.72 |

One can calculate the thicknesses

$$h\ CuO\ = (80)/6,45 = 12\ nm$$

$$h\ Ba = (137.3)/3.76 = 37\ nm$$

$$h\ Cu + BaO = (64)/8.96 + 153/5.72 = 7 + 27 = 34\ nm$$

$$\Delta h = 49 - 34 = 15\ nm\ (30\%).$$

Reduction of the thickness is 30%.

CuO - Be

CuO + Be = Cu+ BeO          (6)

$$\Delta H: \quad 162 + 0 - 609 = -447 \text{ kJ}$$

The reaction is thermodynamically advantageous and is accompanied by heat emission.

In order for the substances to have reacted completely one needs to take 1 mole of CuO and 1 mole of Be, resulting in formation of 1 mole of Cu and 1 mole of BeO.

Taking into account

| Substance | CuO | Cu | Be | BeO |
|---|---|---|---|---|
| Mass 1 mole, g | 80 | 64 | 9 | 25 |
| Density, $g/cm^3$ | 6.45 | 8.96 | 1.85 | 3.01 |

One can calculate the thicknesses

$$h\ CuO = (80)/6.45 = 12.4 \text{ nm}$$

$$h\ Be = (9)/1.85 = 5 \text{ nm}$$

$$h\ Cu + BeO = (64)/8.96 + 25/3.01 = 7 + 8 = 15 \text{ nm}$$

$$\Delta h = 17 - 15 = 2 \text{ nm } (12\%).$$

Reduction of the thickness is 12%.

CuO - Zr

2 CuO + Zr = 2Cu + ZrO$_2$          (7)

$$\Delta H: \quad 2 \cdot 162 + 0 - 1100 = -776 \text{ kJ}$$

The reaction is thermodynamically advantageous and is accompanied by heat emission.

In order for the substances to have reacted completely one needs to take 2 mole of CuO and 1 mole of Zr, resulting in formation of 1 mole of Cu and 1 mole of ZrO$_2$.

Taking into account

| Substance | CuO | Cu | Zr | ZrO$_2$ |
|---|---|---|---|---|
| Mass 1 mole, g | 80 | 64 | 91.2 | 107.2 |
| Density, $g/cm^3$ | 6.45 | 8.96 | 6.45 | 5.86 |

One can calculate

$$\dot{h}\,CuO\ \ = (2{\cdot}80)/6.45 = 25\ nm$$

$$h\,Zr = (91.2)/6.45 = 14\ nm$$

$$h\,Cu + ZrO_2 = (2{\cdot}64)/8.84 + 107.2/5.86 = 14 + 16 = 30nm$$

$$\Delta h = 39 - 30 = 9\ nm\ (24\%).$$

Reduction of thickness is 24%.

CuO - V

$$3CuO + 2V = 3Cu + V_2O_3 \qquad (8)$$

$$\Delta H:\ \ 3{\cdot}162\ \ + 0\ - 1219\ = - 733kJ$$

The reaction is thermodynamically advantageous and is accompanied by heat emission.
In order for the substances to have reacted completely one needs to take 3 mole of CuO and 2 mole of V, resulting in formation of 2 mole of Cu and 1 mole of $V_2O_3$.

| Substance | CuO | Cu | V | $V_2O_3$ |
|---|---|---|---|---|
| Mass 1 mole, g | 80 | 64 | 50 | 100 |
| Density, g/cm$^3$ | 6.45 | 8.96 | 5.96 | 4.87 |

Thicknesses are obtained using the following calculations

$$h\,CuO\ \ = (3{\cdot}80)/6.45 = 37nm$$

$$h\,V = (2{\cdot}50)/5.96 = 17\ nm$$

$$h\,Cu + V_2O_3 = (3{\cdot}64)/8.96 + 100/4.87 = 21 + 21\ nm = 42\ nm$$

$$\Delta h = 57 - 42 = 15\ nm\ (26\%).$$

For full reaction one needs to have 37 nm of CuO film and 17 nm of V film. The reaction will result in shrinkage of the thickness at 26%.

CuO - Si

$$2\,CuO + Si = 2Cu + SiO_2 \qquad (9)$$

$$\Delta H:\ \ 2{\cdot}162\ \ + 0\ - 908\ = - 584\ kJ$$

The reaction is thermodynamically advantageous and is accompanied by heat emission.

In order for the substances to have reacted completely one needs to take 2 mole of CuO and 1 mole of Si, resulting in formation of 2 mole of Cu and 1 mole of $SiO_2$.

| Substance | CuO | Cu | Si | $SiO_2$ |
|---|---|---|---|---|
| Mass 1 mole, g | 80 | 64 | 28 | 60 |
| Density, g/cm$^3$ | 6.45 | 8.96 | 2.33 | 2.65 |

For complete reaction one needs to use the following thicknesses of the films

$$h \ CuO \ = (2 \cdot 80)/6.45 = 25 \ nm$$

$$h \ Si = (28)/2.33 = 12 \ nm$$

$$h \ Cu + SiO_2 = (2 \cdot 64)/8.96 + 60/2.65 = 14 + 22 = 36 \ nm$$

$$\Delta h = 47 - 36 = 11 \ nm \ (24\%).$$

The resulting shrinkage of the film is 24 %.

CuO - Cu

$$CuO + Cu = Cu_2O \qquad (10)$$

$$\Delta H : \quad 162 \quad + 0 \ - 173 \ = - 11 \ kJ$$

The Reaction is thermodynamically advantageous and is accompanied by heat emission.

In order for the substances to have reacted completely one needs to take 1 mole of CuO and 1 mole of Cu, resulting in formation of 1 mole of $Cu_2O$.

| Substance | CuO | Cu | $Cu_2O$ |
|---|---|---|---|
| Mass 1 mole, g | 80 | 64 | 143 |
| Density, g/cm$^3$ | 6.45 | 8.96 | 6.0 |

$$h \ CuO \ = (80)/6.45 = 12.5 \ nm$$

$$h \ Cu = (64)/8.96 = 7.14 \ nm$$

$$h \ Cu_2O = (143)/6.0 + 60/2.65 = 28.83 \ nm$$

$$\Delta h = 12.5 + 7.14 - 28.83 = - 9.19 \ nm \ ( - 46 \ \%).$$

In this case thickness will increase at 46%.

CuO - $H_2$

$$CuO + H_2 = Cu + H_2O \qquad (11)$$

$$\Delta H: \quad 162 \;\; + 0 \; - 285 \; = - 123 \, kJ$$

The reaction is thermodynamically advantageous and is accompanied by heat emission.

| Substance | CuO | Cu |
|---|---|---|
| Mass 1 mole, g | 80 | 64 |
| Density, $g/cm^3$ | 6.45 | 8.96 |

In calculations one can assume that densities of $H_2$ and $H_2O$ are negligibly smaller than those of Cu and CuO and therefore thicknesses are given by

$$h \, CuO \;\; = (80)/6.45 = 12.5 \; nm$$

$$h \, Cu = (64)/8.96 = 7.14 \; nm$$

$$\Delta h = 12.5 - 7.14 = 5.36 \; nm \; (42.8\%).$$

The thickness reduces to 42.8 %.

In the case when Cu is used as a structured material with CuO on top of it (or vice versa), then reduction of Cu from the CuO oxide will result in formation of pure Cu layer with reduced thickness.

Hydrogen can be supplied into the reaction through the top metal as shown in Figure 2. The resulting $H_2O$ molecules can leave the cavity through the top metal too because the water will be in a vapor state. Finally, the cavity will be empty of any gas.

Reduction of Ag from its oxide can be used too.

$Ag_2O$ - $H_2$

$$Ag_2O + H_2 = 2Ag + H_2O \qquad (12)$$

$$\Delta H: \quad 31,1 \;\; + 0 \; - 285 \; = - 254 \, kJ$$

The reaction is thermodynamically advantageous and is accompanied by heat emission.

In order for the substances to have reacted completely one needs to take 1 mole of $Ag_2O$ and 1 mole of $H_2$, resulting in formation of 2 moles of Ag and 1 mole of $H_2O$.

| Substance | $Ag_2O$ | Ag |
|---|---|---|
| Mass 1 mole, g | 231.6 | 107.8 |
| Density, $g/cm^3$ | 7.14 | 10.5 |

For full reaction, the thicknesses per square unit will be

$$h\ Ag_2O = (231.6)/7.14 = 32.4\ nm$$

$$h\ Ag = (2 \cdot 107.8)/10.5 = 20.53\ nm$$

$$\Delta h = 32.4 - 20.53 = 11.86\ nm\ (36.6\%).$$

Resulting shrinkage of the layer will be 36.6%.

$$Re_2O_7 - H_2$$

$$Re_2O_7 + 7H_2 = 7H_2O + 2Re \qquad (13)$$

In order for the substances to have reacted completely one needs to take 1 mole of $Re_2O_7$ and 7 moles of $H_2$, resulting in formation of 2 moles of Re and 7 moles of $H_2O$.
Taking into account the following data

| Substance | $Re_2O_7$ | Re |
|---|---|---|
| Mass 1 mole, g | 484.4 | 186.2 |
| Density, g/cm$^3$ | 8.2 | 21 |

For full reaction, the thicknesses per square unit will be

$$h\ Re_2O_7 = 452.4/8.2 = 59\ nm$$

$$h\ Re = (186 \cdot 2)/21 = 18\ nm$$

$$\Delta h = 59 - 18 = 41\ nm\ (69.9\%).$$

The resulting shrinkage of the layer will be around 70%.
Reduction of Re from $Re_2O_7$ can be made at temperatures between 500 to 1200 °C.
Some semiconductor materials can also be used as a density-changing material. These include

    **1)**       **GeO$_2$ - Al**

$$3GeO_2 + 2\ Al = Al_2O_3 + 3Ge$$

    2)       **SiO$_2$ - Ti**

$$SiO_2 + Ti = TiO_2 + Si$$

    3)       **SiO$_2$ - Al**

$$3\ SiO_2 + 2\ Al = Al_2O_3 + 3Si$$

    4)       $TiS_2$

$TiS_2 + 3O_2 = TiO_2 + 2SO_2$ The above-described methods are not limited to only horizontal gaps. Vertical gaps can also be fabricated. Also, combinations of horizontal and vertical gaps can be made as shown in Figure 12.

**Claims**

1. A method of producing an electromechanical device, comprising:

   forming a layer of density-changing material on a substructure; and
   forming a support layer on at least a portion of said layer of density-changing material,
   wherein said density-changing material has a first density during said forming said layer and a second density subsequent to said forming said support layer, said second density being greater than said first density such that said layer of density-changing material shrinks in at least one dimension to provide a gap between said layer of density changing material and at least one of said support layer and said substructure.

2. A method of producing an electromechanical device according to claim 1, wherein said density-changing material changes density due to a phase change in a structure of said density-changing material.

3. A method of producing an electromechanical device according to claim 1, wherein said density-changing material changes density due to sublimation.

4. A method of producing an electromechanical device according to claim 1, wherein said support layer is formed entirely over said layer of density-changing material such that said layer of density-changing material provides a membrane structure after it shrinks in said at least one dimension to provide a gap.

5. A method of producing an electromechanical device according to claim 4, wherein said support layer and said substructure provide an enclosure such that said gap is substantially a vacuum relative to a surrounding environment.

6. A method of producing an electromechanical device according to claim 1, wherein said support layer is formed over a portion of said layer of density-changing material leaving an end of said density-changing material uncovered such that said layer of density-changing material provides a cantilever structure after it shrinks in said at least one dimension to provide a gap.

7. A method of producing an electromechanical device according to claim 1, wherein said forming said layer of density-changing material comprises forming a first sub layer of a first material and a second sub layer of a second material, wherein said first and second materials chemically react with each other.

8. A method of producing an electromechanical device according to claim 7, wherein said forming said layer of density-changing material further comprises forming a sub layer of a buffer material between said first and second sub layers to regulate a speed of reaction of said first and second materials.

9. A method of producing an electromechanical device according to claim 7, further comprising transferring energy to said layer of density-changing material to initiate a chemical reaction between said first sub layer of said first material and said second sub layer of said second material to cause said layer of density-changing material to shrink in at least one dimension.

10. A method of producing an electromechanical device according to claim 9, wherein said transferring energy includes at least one of heating said layer of density-changing material, passing an electrical current through said layer of density-changing material, or directing electromagnetic radiation onto said layer of density-changing material.

11. A method of producing an electromechanical device according to claim 1, wherein said forming said layer of density-changing material comprises forming a plurality of sub layers of respective pluralities of materials, wherein at least two of said pluralities of materials chemically react with each other.

12. A method of producing an electromechanical device according to any one of claims 1-11, wherein said gap is less than 1 $\mu$m such that said electromechanical device is a micro-electromechanical system.

13. A method of producing an electromechanical device according to any one of claims 1-11, wherein said gap is less than 0.5 $\mu$m such that said electromechanical device is a nano-electromechanical system.

14. A method of producing an electromechanical device according to any one of claims 1-11, wherein said gap is less than 1 $\mu$m and greater than 0.5 nm.

15. A method of producing an electromechanical device according to any one of claims 1-11, wherein said gap is less than 0.5 μm and greater than 0.5 nm.

16. A method of producing an electromechanical device according to any one of claims 1-11, further comprising forming a second layer of a second density-changing material on said support layer,
wherein said second density-changing material has a first density during said forming said second layer and a second density subsequent to said forming said second layer, said second density of said second layer being greater than said first density of said second layer such that said second layer of density-changing material shrinks in at least one dimension to provide a gap between said second layer of density changing material and at least one of said support layer and said first layer of density-changing material.

17. A method of producing a waveguide, comprising:

providing a substructure;
forming a layer of density-changing material on said substructure; and
forming an upper layer on at least a portion of said layer of density-changing material,
wherein said density-changing material has a first density during said forming said layer and a second density subsequent to said forming said upper layer, said second density being greater than said first density such that said layer of density-changing material shrinks in at least one dimension to provide a gap between said layer of density changing material and at least one of said upper layer and said substructure.


**Patentansprüche**

1. Verfahren zur Herstellung einer elektromechanischen Vorrichtung, umfassend:

Ausbilden einer Schicht eines Dichte verändernden Materials auf einer Hilfsstruktur; und
Ausbilden einer Trägerschicht auf zumindest einem Abschnitt der Schicht des Dichte verändernden Materials, wobei das Dichte verändernde Material während des Ausbildens der Schicht eine erste Dichte und nach dem Ausbilden der Trägerschicht eine zweite Dichte aufweist, wobei die zweite Dichte größer als die erste Dichte ist, so dass sich die Schicht des Dichte verändernden Materials in zumindest einer Dimension zusammenzieht, um einen Zwischenraum zwischen der Schicht des Dichte verändernden Materials und der Trägerschicht und/oder dem Substrat bereitzustellen.

2. Verfahren zur Herstellung einer elektromechanischen Vorrichtung nach Anspruch 1, **dadurch gekennzeichnet, dass** das Dichte verändernde Material die Dichte aufgrund eines Phasenübergangs in einer Struktur des Dichte verändernden Materials verändert.

3. Verfahren zur Herstellung einer elektromechanischen Vorrichtung nach Anspruch 1, **dadurch gekennzeichnet, dass** das Dichte verändernde Material die Dichte aufgrund einer Sublimation verändert.

4. Verfahren zur Herstellung einer elektromechanischen Vorrichtung nach Anspruch 1, **dadurch gekennzeichnet, dass** die Trägerschicht vollständig über der Schicht des Dichte verändernden Materials ausgebildet wird, so dass die Schicht des Dichte verändernden Materials eine Membranstruktur bereitstellt, nachdem sie sich in der mindestens einen Dimension zusammengezogen hat, um einen Zwischenraum bereitzustellen.

5. Verfahren zur Herstellung einer elektromechanischen Vorrichtung nach Anspruch 4, **dadurch gekennzeichnet, dass** die Trägerschicht und die Hilfsstruktur eine Einfassung bereitstellen, so dass der Zwischenraum im Wesentlichen ein Vakuum relativ zu einem umgebenden Umfeld ist.

6. Verfahren zur Herstellung einer elektromechanischen Vorrichtung nach Anspruch 1, **dadurch gekennzeichnet, dass** die Trägerschicht über einem Abschnitt der Schicht des Dichte verändernden Materials ausgebildet wird, wobei ein Ende des Dichte verändernden Materials unabgedeckt belassen wird, so dass die Schicht des Dichte verändernden Materials eine freitragende Struktur bereitstellt, nachdem sie sich in mindestens einer Dimension zusammengezogen hat, um einen Zwischenraum bereitzustellen.

7. Verfahren zur Herstellung einer elektromechanischen Vorrichtung nach Anspruch 1, **dadurch gekennzeichnet, dass** das Ausbilden der Schicht des Dichte verändernden Materials ein Ausbilden einer ersten Hilfsschicht eines ersten Materials und einer zweiten Hilfsschicht eines zweiten Materials umfasst, wobei das erste und das zweite Material chemisch miteinander reagieren.

8. Verfahren zur Herstellung einer elektromechanischen Vorrichtung nach Anspruch 7, **dadurch gekennzeichnet, dass** das Ausbilden der Schicht des Dichte verändernden Materials darüber hinaus ein Ausbilden einer Hilfsschicht eines Puffermaterials zwischen der ersten und der zweiten Hilfsschicht umfasst, um eine Reaktionsgeschwindigkeit des ersten und des zweiten Materials zu regulieren.

9. Verfahren zur Herstellung einer elektromechanischen Vorrichtung nach Anspruch 7, darüber hinaus ein Übertragen von Energie zu der Schicht des Dichte verändernden Materials umfassend, um eine chemische Reaktion zwischen der ersten Hilfsschicht des ersten Materials und der zweiten Hilfsschicht des zweiten Materials zu verursachen, um zu bewirken, dass sich die Schicht des Dichte verändernden Materials in der mindestens einen Dimension zusammenzieht.

10. Verfahren zur Herstellung einer elektromechanischen Vorrichtung nach Anspruch 9, **dadurch gekennzeichnet, dass** das Übertragen von Energie ein Aufheizen der Schicht des Dichte verändernden Materials, ein Führen eines elektrischen Stroms durch die Schicht des Dichte verändernden Materials und/oder ein Lenken einer elektromagnetischen Strahlung auf die Schicht des Dichte verändernden Materials aufweist.

11. Verfahren zur Herstellung einer elektromechanischen Vorrichtung nach Anspruch 1, **dadurch gekennzeichnet, dass** das Ausbilden der Schicht des Dichte verändernden Materials ein Ausbilden von mehreren Hilfsschichten von entsprechenden Materialien umfasst, wobei mindestens zwei der mehreren Materialien chemisch miteinander reagieren.

12. Verfahren zur Herstellung einer elektromechanischen Vorrichtung nach einem der Ansprüche 1-11, **dadurch gekennzeichnet, dass** der Zwischenraum kleiner als 1 pm ist, so dass die elektromechanische Vorrichtung ein mikroelektromechanisches System ist.

13. Verfahren zur Herstellung einer elektromechanischen Vorrichtung nach einem der Ansprüche 1-11, **dadurch gekennzeichnet, dass** der Zwischenraum kleiner als 0,5 $\mu$m ist, so dass die elektromechanische Vorrichtung ein nanoelektromechanisches System ist.

14. Verfahren zur Herstellung einer elektromechanischen Vorrichtung nach einem der Ansprüche 1-11, **dadurch gekennzeichnet, dass** der Zwischenraum kleiner als 1 $\mu$m und größer als 0,5 nm ist.

15. Verfahren zur Herstellung einer elektromechanischen Vorrichtung nach einem der Ansprüche 1-11, **dadurch gekennzeichnet, dass** der Zwischenraum kleiner als 0,5 $\mu$m und größer als 0,5 nm ist.

16. Verfahren zur Herstellung einer elektromechanischen Vorrichtung nach einem der Ansprüche 1-11, darüber hinaus ein Ausbilden einer zweiten Schicht eines zweiten Dichte verändernden Materials auf der Trägerschicht umfassend, wobei das zweite Dichte verändernde Material eine erste Dichte während des Ausbildens der zweiten Schicht und eine zweite Dichte nach dem Ausbilden der zweiten Schicht aufweist, wobei die zweite Dichte der zweiten Schicht größer als die erste Dichte der zweiten Schicht ist, so dass sich die zweite Schicht des Dichte verändernden Materials in mindestens einer Dimension zusammenzieht, um einen Zwischenraum zwischen der zweiten Schicht des Dichte verändernden Materials und der Trägerschicht und/oder der ersten Schicht des Dichte verändernden Materials bereitzustellen.

17. Verfahren zur Herstellung eines Wellenleiters, umfassend:

Bereitstellen einer Hilfsstruktur;
Ausbilden einer Schicht eines Dichte verändernden Materials auf der Hilfsstruktur; und
Ausbilden einer oberen Schicht auf zumindest einem Abschnitt der Schicht des Dichte verändernden Materials, wobei das Dichte verändernde Material eine erste Dichte während des Ausbildens der Schicht und eine zweite Dichte nach dem Ausbilden der oberen Schicht aufweist, wobei die zweite Dichte größer als die erste Dichte ist, so dass sich die Schicht des Dichte verändernden Materials in mindestens einer Dimension zusammenzieht, um einen Zwischenraum zwischen der Schicht des Dichte verändernden Materials und der oberen Schicht und/oder der Hilfsstruktur bereitzustellen.

**Revendications**

1. Procédé de production d'un dispositif électromécanique, comprenant :

   la formation d'une couche d'un matériau à changement de densité sur une substructure ; et
   la formation d'une couche support sur au moins une partie de ladite couche de matériau à changement de densité, dans lequel ledit matériau à changement de densité a une première densité au cours de ladite formation de ladite couche et une seconde densité après ladite formation de ladite couche support, ladite seconde densité étant supérieure à ladite première densité, de manière telle que ladite couche de matériau à changement de densité se rétracte dans au moins une dimension, pour fournir un interstice formé entre ladite couche de matériau à changement de densité et au moins l'une ou l'autre de ladite couche support et de ladite substructure.

2. Procédé de production d'un dispositif électromécanique selon la revendication 1, dans lequel ledit matériau à changement de densité change de densité en raison d'un changement de phase dans une structure dudit matériau à changement de densité.

3. Procédé de production d'un dispositif électromécanique selon la revendication 1, dans lequel ledit matériau à changement de densité change de densité en raison de la sublimation.

4. Procédé de production d'un dispositif électromécanique selon la revendication 1, dans lequel ladite couche support est formée entièrement par-dessus ladite couche de matériau à changement de densité, de manière telle que ladite couche de matériau à changement de densité fournisse une structure à membrane, après que ladite couche se rétracte dans ladite au moins une dimension, pour fournir un interstice.

5. Procédé de production d'un dispositif électromécanique selon la revendication 4, dans lequel ladite couche support et ladite substructure fournissent une enceinte, de manière telle que ledit interstice soit substantiellement un vide par rapport à un milieu environnant.

6. Procédé de production d'un dispositif électromécanique selon la revendication 1, dans lequel ladite couche support est formée par-dessus une partie de ladite couche de matériau à changement de densité, laissant une extrémité dudit matériau à changement de densité non recouverte, de manière telle que ladite couche de matériau à changement de densité fournisse une structure en porte-à-faux, après que ladite couche se rétracte dans ladite au moins une dimension, pour fournir un interstice.

7. Procédé de production d'un dispositif électromécanique selon la revendication 1, dans lequel ladite formation de ladite couche de matériau à changement de densité comprend la formation d'une première sous-couche d'un premier matériau et d'une seconde sous-couche d'un second matériau, où lesdits premier et second matériaux réagissent chimiquement l'un avec l'autre.

8. Procédé de production d'un dispositif électromécanique selon la revendication 7, dans lequel ladite formation de ladite couche de matériau à changement de densité comprend en outre la formation d'une sous-couche d'un matériau tampon entre lesdites première et seconde sous-couches, pour réguler une vitesse de réaction desdits premier et second matériaux.

9. Procédé de production d'un dispositif électromécanique selon la revendication 7, comprenant en outre le transfert d'énergie à ladite couche de matériau à changement de densité, pour déclencher une réaction chimique entre ladite première sous-couche dudit premier matériau et ladite seconde sous-couche dudit second matériau, pour provoquer le retrait de ladite couche de matériau à changement de densité dans au moins une dimension.

10. Procédé de production d'un dispositif électromécanique selon la revendication 9, dans lequel ledit transfert d'énergie comprend au moins l'une des étapes consistant à chauffer ladite couche de matériau à changement de densité, à faire passer un courant électrique dans ladite couche de matériau à changement de densité ou à diriger un rayonnement électromagnétique sur ladite couche de matériau à changement de densité.

11. Procédé de production d'un dispositif électromécanique selon la revendication 1, dans lequel ladite formation de ladite couche de matériau à changement de densité comprend la formation d'une pluralité de sous-couches de pluralités respectives de matériaux, où au moins deux desdites pluralités de matériaux réagissent chimiquement l'une avec l'autre.

**12.** Procédé de production d'un dispositif électromécanique selon l'une quelconque des revendications 1 à 11, dans lequel ledit interstice est inférieur à 1 $\mu$m, de manière telle que ledit dispositif électromécanique soit un système micro-électromécanique.

**13.** Procédé de production d'un dispositif électromécanique selon l'une quelconque des revendications 1 à 11, dans lequel ledit interstice est inférieur à 0,5 $\mu$m, de manière telle que ledit dispositif électromécanique soit un système nano-électromécanique.

**14.** Procédé de production d'un dispositif électromécanique selon l'une quelconque des revendications 1 à 11, dans lequel ledit interstice est inférieur à 1 $\mu$m et supérieur à 0,5 nm.

**15.** Procédé de production d'un dispositif électromécanique selon l'une quelconque des revendications 1 à 11, dans lequel ledit interstice est inférieur à 0,5 $\mu$m et supérieur à 0,5 nm.

**16.** Procédé de production d'un dispositif électromécanique selon l'une quelconque des revendications 1 à 11, comprenant en outre la formation, sur ladite couche support, d'une seconde couche d'un second matériau à changement de densité,
dans lequel ledit second matériau à changement de densité a une première densité au cours de ladite formation de ladite seconde couche et une seconde densité après ladite formation de ladite seconde couche, ladite seconde densité de ladite seconde couche étant supérieure à ladite première densité de ladite seconde couche, de manière telle que ladite seconde couche de matériau à changement de densité se rétracte dans au moins une dimension, pour fournir un interstice formé entre ladite seconde couche de matériau à changement de densité et au moins une de ladite couche support et de ladite première couche de matériau à changement de densité.

**17.** Procédé de production d'un guide d'ondes, comprenant :

la fourniture d'une substructure ;
la formation d'une couche d'un matériau à changement de densité sur ladite substructure ; et
la formation d'une couche supérieure sur au moins une partie de ladite couche de matériau à changement de densité,
dans lequel ledit matériau à changement de densité a une première densité au cours de ladite formation de ladite couche et une seconde densité après ladite formation de ladite couche supérieure, ladite seconde densité étant supérieure à ladite première densité, de manière telle que ladite couche de matériau à changement de densité se rétracte dans au moins une dimension, pour fournir un interstice formé entre ladite couche de matériau à changement de densité et au moins l'une ou l'autre de ladite couche supérieure et de ladite substructure.

Figure 1

Figure 2

Figure 3

Figure 4

Figure 5

17  52  44  18

16  25

## Figure 6

Figure 7

Figure 8

Figure 9

a)

V15  49  67  50
41  42  69  65  49  43

V11  V10  V12

40

b)

F3

c)

66  F22  65
69  67
F11  F12
F21  68

Figure 10

a)

b)

Figure 11

Figure 12

Figure 13

Figure 14

Figure 15

a)

b)

c)

# Figure 16

# Prototype microchip

- The microchip comprises multiple devices
- Packaged in a standard chip package LCC48
- Gold and aluminium bonding

Figure 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050130360 A
- US 20050036269 A
- US 37088209 A, A. Pavlov